(19) Europäisches Patentamt
European Patent Office
Office européen des brevets

(11) **EP 3 430 359 B1**

(12) **EUROPÄISCHE PATENTSCHRIFT**

(45) Veröffentlichungstag und Bekanntmachung des Hinweises auf die Patenterteilung:
**07.04.2021 Patentblatt 2021/14**

(51) Int Cl.:
*G01D 5/20* (2006.01)     *H03M 1/20* (2006.01)

(21) Anmeldenummer: **17710147.4**

(86) Internationale Anmeldenummer:
**PCT/EP2017/054617**

(22) Anmeldetag: **28.02.2017**

(87) Internationale Veröffentlichungsnummer:
**WO 2017/157652 (21.09.2017 Gazette 2017/38)**

(54) **VORRICHTUNG ZUM MESSEN EINER MESSGRÖSSE**

APPARATUS FOR MEASURING A VARIABLE

DISPOSITIF POUR MESURER UNE GRANDEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.03.2016 DE 102016204417**

(43) Veröffentlichungstag der Anmeldung:
**23.01.2019 Patentblatt 2019/04**

(73) Patentinhaber: **Continental Teves AG & Co. OHG 60488 Frankfurt am Main (DE)**

(72) Erfinder: **ACKER, Heinrich 65824 Schwalbach (DE)**

(74) Vertreter: **Continental Corporation c/o Continental Teves AG & Co. OHG Intellectual Property Guerickestraße 7 60488 Frankfurt a. Main (DE)**

(56) Entgegenhaltungen:
**EP-A1- 2 105 713       EP-A2- 2 765 391
WO-A1-2017/025354   DE-T2- 69 322 762
JP-A- 2004 128 902**

EP 3 430 359 B1

**Beschreibung**

Die Erfindung betrifft eine Vorrichtung zum Messen einer Messgröße. Dabei kann es sich beispielsweise um eine Vorrichtung handeln, welche auch als Sensor bezeichnet werden kann. Eine solche Vorrichtung kann beispielsweise dazu ausgebildet sein, eine Messgröße in Form eines Wegs aufzunehmen, beispielsweise um die Position eines Pedals in einem Automobil festzustellen.

EP 2 105 713 A1 betrifft ein Positionsmessgerät mit einer elektronischen Steuerungseinheit, einem durch diese oszillierend anregbaren Parallelschwingkreis und mehreren Messinduktivitäten.

EP 2 765 391 A2 offenbart einen transformatorbasierten Positionssensor.

DE 693 22 762 T2 offenbart ein System zur Analog-Digital-Umsetzung, bei der ein Verzerrsignal verwendet wird.

In der WO 2017/025 354 A1 ist eine Vorrichtung zum Messen einer Messgröße gezeigt, wobei es sich bei dieser Vorrichtung um einen induktiven Sensor handeln kann.

Bekannte Vorrichtungen weisen unterschiedliche Nachteile auf. Beispielsweise ist eine Skalierung auf mehrere Eingänge meist nur mit großem Aufwand möglich. Des Weiteren wird die Genauigkeit der Erfassung einer Messgröße häufig durch die in einem verwendeten Mikrocontroller verfügbare Bitbreite eines Analog-Digital-Konverters begrenzt. Hier kann zwar beispielsweise das bekannte Dithering Abhilfe schaffen, bei welchem durch das Anlegen eines schnellen Überlagerungssignals genauer gemessen werden kann, als dies die eigentliche Bitbreite eines Analog-Digital-Konverters erlaubt, jedoch ist dies bei bekannten Ausführungen mit einem hohen zusätzlichen Schaltungsaufwand verbunden.

Der jeweils erforderliche zusätzliche Aufwand ist zwar grundsätzlich technisch realisierbar, jedoch handelt es sich bei den hier beschriebenen Vorrichtungen um Massenprodukte, bei welchen die Herstellungskosten eine erhebliche Rolle spielen.

Es ist deshalb eine Aufgabe der Erfindung, eine Vorrichtung zum Messen einer Messgröße vorzusehen, welche alternativ, beispielsweise günstiger herstellbar ausgeführt ist.

Dies wird erfindungsgemäß durch eine Vorrichtung gemäß Anspruch 1 erreicht. Vorteilhafte Ausgestaltungen können beispielsweise den Unteransprüchen entnommen werden. Der Inhalt der Ansprüche wird durch ausdrückliche Inbezugnahme zum Inhalt der Beschreibung gemacht.

Die Erfindung betrifft eine Vorrichtung zum Messen einer Messgröße. Die Vorrichtung weist eine erste Induktivität auf. Außerdem weist die Vorrichtung zumindest eine Messinduktivität auf, welche zum Abfühlen der Messgröße ausgebildet ist und welche mit der ersten Induktivität gekoppelt ist. Es kann sich dabei sowohl um eine Messinduktivität wie auch um eine Mehrzahl von Messinduktivitäten, beispielsweise zwei, drei, vier oder mehr Messinduktivitäten handeln.

Bei der Messgröße kann es sich beispielsweise um einen Weg handeln, welchen ein technisches Element wie beispielsweise ein Pedal in einem Automobil oder eine Komponente einer Federung zurücklegt bzw. eine Position, welche ein solches Element einnimmt.

Die Vorrichtung weist des Weiteren eine Kapazität auf, welche mit der ersten Induktivität zu einem Parallelschwingkreis verschaltet ist. Außerdem weist die Vorrichtung eine elektronische Steuerungseinheit auf. Die elektronische Steuerungseinheit ist direkt mit dem Parallelschwingkreis verbunden und dazu konfiguriert, den Parallelschwingkreis mit einer Anregungsfrequenz oszillierend anzuregen, welche aus einem Takt der elektronischen Steuerungseinheit abgeleitet ist.

Bei der elektronischen Steuerungseinheit kann es sich beispielsweise um einen Mikrocontroller, einen Mikroprozessor, einen Anwendungsspezifischen Integrierten Schaltkreis (ASIC), ein Field Programmable Gate Array (FPGA), oder um eine andere programmierbare oder festverdrahtete Komponente handeln. Eine direkte Verbindung mit dem Parallelschwingkreis kann beispielsweise ausschließlich zur Verwendung von Drähten oder anderen elektrisch leitfähigen Verbindungen ausgeführt sein, sie kann jedoch auch Komponenten wie beispielsweise Widerstände beinhalten. Durch das Anregen mit einer Anregungsfrequenz wird der Parallelschwingkreis in Schwingung versetzt. Ein Takt der elektronischen Steuerungseinheit kann beispielsweise aus einem internen Oszillator, einem externen Oszillator, einer internen oder externen Taktquelle oder aus einer sonstigen Quelle stammen. Letztlich bedeutet die Anregung mit einer Anregungsfrequenz, welche aus einem Takt der elektronischen Steuerungseinheit abgeleitet ist typischerweise, dass die Anregungsfrequenz seitens der elektronischen Steuerungseinheit vorgegeben wird.

Die elektronische Steuerungseinheit weist einen Analog-Digital-Konverter mit zumindest einem Signaleingang auf, welcher direkt mit der zumindest einen Messinduktivität zum Aufnehmen eines Signals verbunden ist. Dies ermöglicht das Aufnehmen eines Spannungswerts von der Messinduktivität. Der Spannungswert stellt typischerweise das Signal dar. Es sei verstanden, dass beispielsweise die elektronische Steuerungseinheit auch mehrere Analog-Digital-Konverter mit einem jeweiligen Signaleingang aufweisen kann, wobei jeder Signaleingang mit einer jeweiligen Messinduktivität beim Vorhandensein mehrerer Messinduktivitäten verbunden sein kann. Ebenso ist es jedoch auch möglich, dass beispielsweise ein Analog-Digital-Konverter über einen Multiplexer auf mehrere Messinduktivitäten verschaltet wird.

Die elektronische Steuerungseinheit weist einen Verzerrsignal-Generator mit einem Verzerrsignal-Ausgang auf, wobei der Verzerrsignal-Generator dazu ausgebildet ist, an einem Verzerrsignal-Referenzpunkt ein Verzerrsignal zu liefern. Dieses Verzerrsignal ermöglicht eine Verwendung von Dithering, um die Auflösung des Analog-Digital-Konverters über die rein aufgrund seiner Bitbreite abgeleitete mögliche Auflösung hinaus zu verfeinern. Der Verzerrsignal-Referenzpunkt kann dabei sowohl unmittelbar an einem Pin oder einem Ausgang der elektronischen Steuerungseinheit liegen, er kann jedoch auch in einer externen Beschaltung der elektronischen Steuerungseinheit liegen, wie weiter unten beispielhaft beschrieben werden wird.

Der Verzerrsignal-Ausgang ist ausschließlich mittels passiver Komponenten an den Analog-Digital-Konverter gekoppelt. Der Erfinder der vorliegenden Anmeldung hat erkannt, dass zum Koppeln des Verzerrsignal-Ausgangs an den Analog-Digital-Konverter nicht zwingend aktive Komponenten wie beispielsweise ein Operationsverstärker nötig sind. Vielmehr ist es durchaus auch möglich, wie hier beschrieben den Verzerrsignal-Ausgang ausschließlich mittels passiver Komponenten an den Analog-Digital-Konverter zu koppeln, also eine Überlagerung des Verzerrsignals mit einem zu messenden Signal durchzuführen, wodurch im Vergleich zur Verwendung aktiver Komponenten eine erhebliche Einsparung der Kosten erfolgt.

Die elektronische Steuerungseinheit ist dazu konfiguriert, das Signal in Intervallen zu messen, wobei innerhalb jedes Intervalls eine Anzahl von Messwerten aufgenommen wird. Des Weiteren ist die elektronische Steuerungseinheit dazu konfiguriert, eine Frequenzanalyse der Messwerte eines jeweiligen Intervalls durchzuführen und zumindest einen die Messgröße anzeigenden Kennwert des Signals bei einer Auswertungsfrequenz zu bestimmen.

Durch die beschriebene Frequenzanalyse kann in besonders vorteilhafter Weise ein die Messgröße anzeigender Kennwert erhalten werden, wobei insbesondere auch besonderen Konstellationen hinsichtlich der verwendeten Frequenzen Rechnung getragen werden kann. Hierauf wird weiter unten näher eingegangen werden.

Mittels der erfindungsgemäßen Vorrichtung kann auf besonders effiziente und kostengünstige Weise eine Messgröße gemessen werden. Hierbei kann sowohl eine nahezu beliebige Skalierung hinsichtlich der Anzahl der verwendeten Messinduktivitäten erfolgen wie auch eine Auflösung erreicht werden, welche deutlich besser ist als die aus der Bitbreite des Analog-Digital-Konverters zu vermutende Auflösung. Dies alles ist bei einem minimalen Aufwand und minimalen Kosten möglich.

Die Messwerte sind bevorzugt um jeweilige Zeitdifferenzen beabstandet, wobei diese einer Unterabtastung des Signals entsprechen. Eine solche Unterabtastung kann vorteilhaft eingesetzt werden, um Frequenzen zu messen, welche deutlich über den ansonsten möglichen maximalen Frequenzen liegen. Derartige hohe Frequenzen können gerade in der hier beschriebenen Konstellation einer Messung durch Verwendung von Messinduktivitäten besonders günstig sein, da bei der Übertragung einer Wechselspannung nach dem Transformatorprinzip die induzierte Spannung und damit auch die Genauigkeit der Messung umso größer wird, je höher die Frequenz ist.

Gemäß einer Ausführung ist die Auswertungsfrequenz die Anregungsfrequenz. Dies entspricht insbesondere einer besonders einfachen Ausführung.

Gemäß einer Ausführung ist die Auswertungsfrequenz ein Alias der Anregungsfrequenz. Dabei wird insbesondere der Effekt des Aliasings berücksichtigt. Insbesondere hierdurch kann die Anregungsfrequenz wesentlich höher sein als die Frequenz, welche ansonsten mit der beschriebenen Konstellation ohne Berücksichtigung von Unterabtastung messbar wäre.

Die produktive Nutzung des sonst meist störenden Aliasing geschieht bevorzugt folgendermaßen: Am Eingang des Analog-Digital-Konverters befindet sich ein Signal der Anregungsfrequenz, welches durch die Abtastrate am Analog-Digital-Konverter eine Unterabtastung erfährt. Ohne weitere Signalverarbeitungsschritte entsteht am Ausgang des Analog-Digital-Konverters ein Signalspektrum, bei dem die Anregungsfrequenz auf einen Wert unterhalb der Nyquist-Frequenz der Abtastrate des Analog-Digital-Konverters transformiert wird. Dieser Wert entspricht bevorzugt der Auswertungsfrequenz, die durch die spektrale Auswertung des Ausgangssignals des Analog-Digital-Konverters gemessen wird.

Bevorzugt umfasst ein jeweiliges Messintervall eine ganzzahlige Anzahl von Perioden des Signals. Dies erlaubt eine besonders vorteilhafte Frequenzanalyse.

Bevorzugt weist ein jeweiliges Messintervall eine ganzzahlige Anzahl von Halbschwingungen des Verzerrsignals auf. Besonders bevorzugt weist es eine oder zwei Halbschwingungen auf. Dadurch wird sichergestellt, dass insbesondere bei Verwendung eines deterministischen Verzerrsignals keine Verfälschung des Messergebnisses durch das Verzerrsignal erfolgt.

Bevorzugt ist der Verzerrsignal-Ausgang ohne aktive Komponenten, insbesondere ohne Operationsverstärker, an den Analog-Digital-Konverter gekoppelt. Diese Formulierung kann als Alternative zur Formulierung verwendet werden, dass der Verzerrsignal-Ausgang ausschließlich unter Verwendung passiver Komponenten an den Analog-Digital-Konverter gekoppelt ist. Dementsprechend können diese Formulierungen auch ausgetauscht werden.

Die Messinduktivitäten sind bevorzugt mit einem jeweiligen ersten Pol an einem jeweiligen Signaleingang der elektronischen Steuerungseinheit angeschlossen. Weiter bevorzugt sind sie mit einem jeweiligen zweiten Pol mit einem gemeinsamen Potentialpunkt verbunden. Dies ermöglicht es, die Messinduktivitäten mit einem gemeinsamen, einstellbaren Potential zu versorgen.

An dem Potentialpunkt kann zumindest annähernd oder auch exakt die halbe Versorgungsspannung der elektronischen Steuerungseinheit anliegen. Dies hat sich als vorteilhaft erwiesen, da in diesem Fall Abweichungen in beide Richtungen idealerweise gemessen werden können.

Bevorzugt ist der Potentialpunkt der Verzerrsignal-Referenzpunkt. Dies kann insbesondere bedeuten, dass das Verzerrsignal einem gewünschten, zumindest in etwa einzustellenden Potential am Potentialpunkt überlagert wird. Der Potentialpunkt kann in diesem Fall insbesondere den Ausgangspunkt für eine weitere Signalmodulation in den Messinduktivitäten aufgrund der Messgröße darstellen. Als solcher Ausgangspunkt wird dem Potentialpunkt als Verzerrsignal-Referenzpunkt das Verzerrsignal überlagert, welches somit bereits im durch die Messgröße zu ändernden Signal enthalten ist.

Zwischen dem Verzerrsignal-Ausgang und dem Potentialpunkt kann insbesondere ein Widerstand geschaltet sein, wobei der Potentialpunkt über einen Glättungskondensator mit einem Bezugspotential oder mit der Versorgungsspannung verbunden ist. Dadurch kann mittels des Verzerrsignal-Ausgangs das Potential am Potentialpunkt eingestellt werden. Insbesondere kann dies durch eine Pulsweitenmodulation erfolgen.

Dementsprechend kann vorzugsweise am Verzerrsignal-Ausgang ein gepulstes Signal anliegen, welches insbesondere ein vorgebbares Tastverhältnis haben kann.

Der Kennwert kann insbesondere eine Amplitude, eine Phase, ein Realteil und/oder ein Imaginärteil sein. Jede beliebige Kombination von einem dieser Werte, zwei dieser Werte, drei dieser Werte oder allen Werten kann verwendet werden. Der Kennwert kann also auch mehrere Komponenten haben, beispielsweise kann er als Komponenten Amplitude und Phase aufweisen oder er kann als Komponenten Realteil und Imaginärteil aufweisen. Er kann beispielsweise auch Amplitude, Phase, Realteil und Imaginärteil sowie jede andere Untergruppe der erwähnten Werte sowie weitere Werte aufweisen. Im Wesentlichen wird die Zusammensetzung des Kennwerts, gegebenenfalls auch als mehrdimensionale oder mehrkomponentige Größe, von der jeweiligen Anwendung abhängen.

Nachfolgend werden mehrere allgemeine Ausführungen zur Erfindung gegeben, wobei erwähnt sei, dass alle nachfolgend beschriebenen Ausführungen, Merkmale und Varianten beliebig mit den ansonsten in dieser Anmeldung beschriebenen Ausführungen, Merkmalen oder Varianten kombiniert werden können.

Mikrocontroller sind integraler Bestandteil vieler Sensorsysteme, weil Sensorfunktionen der Signalverarbeitung wie etwa Filterung oder Störgrößenunterdrückung sich flexibel und kostengünstig digital in Software darstellen lassen. Da das eigentliche Sensorsystem, welches die physikalische Parameterabhängigkeit der Messgröße zeigt, praktisch immer als analog aufzufassen ist, kommt im Sensorsystem einem Analog-Digital-Konverter (ADC) eine zentrale Bedeutung zu. Die meisten Mikrocontroller enthalten integrierte Analog-Digital-Konverter, weil die gemeinsame Realisierung der notwendigen Komponenten in einem integrierten Schaltkreis die Systemkosten reduzieren hilft.

In Mikrocontrollern integrierte Analog-Digital-Konverter weisen meistens Bitbreiten bzw. Wortbreiten von 8 Bit bis 12 Bit auf. Die größte Verbreitung am Markt haben Systeme mit 10 Bit. Bei eigenständigen Analog-Digital-Konvertern haben dagegen Wortbreiten von 12 bis 16 Bit hohe Verbreitung. Grund für den Unterschied ist die Schwierigkeit, hochwertige analoge elektronische Komponenten zusammen mit dem Mikrocontroller auf einem integrierten Schaltkreis (IC) kostengünstig zu integrieren. Dadurch ist die effektive Auflösung (ENOB) begrenzt und die Hersteller sind bestrebt, die Wortbreite höher, aber nicht deutlich höher als die effektive Auflösung anzusetzen.

Eine Wortbreite oder effektive Auflösung von 10 Bit reicht für viele Anwendungen nicht aus. Demgegenüber haben die Analog-Digital-Konverter in modernen Mikrocontrollern oft eine maximale Abtastrate von 100 kHz bis 200 kHz, während die Bandbreite der Messgrößen in der Sensorik im Automobilbereich meistens unterhalb von 1 kHz liegt. Es ist also eine deutliche Überabtastung der Messgröße möglich. Daher kann in Betracht gezogen werden, aus vielen Werten mit niedriger Auflösung wenige Werte mit hoher Auflösung zu erzeugen. Ein bekanntes Verfahren hierzu ist das sogenannte "Dithering" (englisch für "zittern"). Dabei wird zum Eingangssignal ein Rauschen mit geringem Effektivwert in der Größenordnung weniger LSB (Least Significant Bit) addiert. Die Folge ist, dass der Ausgangswert, welchen der Analog-Digital-Konverter bei konstantem Eingangssignal annimmt, zufällig wird. Er schwingt um den dem Eingangssignal entsprechenden Wert mit dem Augenblickswert des Rauschens. Hat das Rauschen den Mittelwert null, so wird der Mittelwert vieler Ausgangswerte des Analog-Digital-Konverters dem konkreten Ausgangswert des konstanten Eingangssignals entsprechen, jedoch weist der Mittelwert eine höhere Auflösung auf. Bei der Mittelwertbildung entstehen nämlich Stellen (Ziffern) mit einer geringeren Wertigkeit als ein LSB. Dieses Verfahren wird "Random Dithering" genannt, ein deutscher Begriff ist nicht üblich.

Das "Random Dithering" löst die gestellte Aufgabe, jedoch ist der Gewinn an effektiver Auflösung bei Kombination einer nur geringen Anzahl von beispielsweise 50 Ausgangswerten des Analog-Digital-Konverters ebenfalls nur gering, weil das Rauschen bei einer so geringen Anzahl von Werten keine hinreichende stochastische Gleichförmigkeit aufweisen kann. Dies kann insbesondere bedeuten, dass der Mittelwert jeder Gruppe von zum Beispiel 50 aufeinanderfolgenden Werten des Rauschens sich signifikant von null unterscheidet. Daher kann anstelle echten Rauschens, d.h. der Werte eines tatsächlich zufälligen Prozesses, häufig Pseudorauschen verwendet werden, d.h. eine quasizufällige Reihe von Werten, welche tatsächlich aber so gestaltet wurden, dass die gewünschten stochastischen Eigenschaften für jede Gruppe gegeben sind, insbesondere ein Mittelwert von null. Die Performance in dem genannten Kontext ist bei einer konstanten, geringen Anzahl von Ausgangswerten des Analog-Digital-Konverters aus diesem Grund deutlich höher als beim "Random Dithering". Dieses bekannte Verfahren wird "Deterministic Dithering" genannt, ein deutscher Begriff ist nicht üblich.

Für die Funktionsweise des "Deterministic Dithering" ist es nicht notwendig, dass das addierte Dither-Signal bzw. Verzerrsignal die Anmutung von Rauschen hat. Hat man den Schritt vom "Random Dithering" zum "Deterministic Dithering" vollzogen, fällt auf, dass auch ein einfaches definiertes Signal wie etwa ein Dreieck- oder Sägezahnsignal die Anforderungen erfüllt. Dabei kommt es für die Erfüllung der Hauptbedingung eines Mittelwerts gleich null lediglich darauf an, dass der Zeitraum, aus dem die Abtastwerte stammen, die zu einem Wert gemittelt werden, eine ganzzahlige Anzahl von Perioden des Dither-Signals bzw. Verzerrsignals umfasst. Es reicht typischerweise tatsächlich sogar aus, wenn der Mittelwert konstant und bekannt ist, weil jeder solche Wert auf der digitalen Seite rechnerisch wieder entfernt werden kann.

Zur Lösung der Aufgabe sind gemäß dem Stand der Technik folgende Komponenten erforderlich:

1. Generator für das Verzerrsignal,
2. Addierer,
3. Analog-Digital-Konverter (ADC),
4. Mikrocontroller (bildet Mittelwert).

Weiterhin soll, um die Bedingung der ganzzahligen Anzahl von Perioden des Verzerrsignals zu erfüllen, eine Synchronisation von Generator und Analog-Digital-Konverter erfolgen.

Da, wie bereits erwähnt, typischerweise Analog-Digital-Konverter und Mikrocontroller integriert sind, besteht eine Lösung gemäß dem Stand der Technik aus dem Mikrocontroller sowie dem Addierer und einem Generator als externe Komponenten.

Insbesondere kann eine Lösung nach dem Stand der Technik für den Fall eines mehrkanaligen Messsystems einen Addierer pro Kanal aufweisen. Somit steigt der Schaltungsaufwand mit der Anzahl der Kanäle deutlich an, wodurch mehrkanalige Systeme, welche hinsichtlich ihrer messtechnischen Eigenschaften attraktiv sind, über die Kosten diese Attraktivität zumindest teilweise wieder einbüßen.

Wie vom Erfinder der vorliegenden Anmeldung erkannt wurde, kann die Funktion eines Addierers mit einer lediglich passiven Außenbeschaltung eines Mikrocontrollers erzielt werden. Jedoch wird dabei insbesondere für den häufigen Fall, dass weder ein differenzieller Eingang des Analog-Digital-Konverters vorliegt noch ein Referenzeingang des Analog-Digital-Konverters genutzt werden kann, eine passive Addierschaltung pro Kanal gebaut werden. Hierdurch ist die Gesamtschaltung bei einer größeren Anzahl von Kanälen immer noch relativ kostengünstig im Vergleich zum Stand der Technik (Addierverstärker), die Schaltung besteht jedoch immer noch aus einer Vielzahl von Bauelementen, deren Gesamtkosten nicht zuletzt wegen Bestückung und belegter Platinenfläche noch eine weitere Optimierung sinnvoll scheinen lassen.

Weiterhin erscheint es sinnvoll, eine universelle Verwendbarkeit zu erreichen, insbesondere indem Frequenzbereiche des Verzerrsignals und des zu messenden Signals nicht mehr getrennt werden.

Die Verwendung von Dithering gemäß dem Stand der Technik weist die Einschränkung auf, dass das zu messende Signal sich in jedem Zeitintervall, dessen Mittelwert gebildet wird, nur vernachlässigbar ändern darf. Es wäre jedoch wünschenswert, die positiven Eigenschaften des Dithering, insbesondere des "Deterministic Dithering", mit einer deutlich reduzierten Außenbeschaltung des Mikrocontrollers zu erreichen und dadurch Kosten zu sparen, wobei die beschriebenen Einschränkungen entfallen sollen.

Zunächst wird vorgeschlagen, einen Addierer zu ersetzen.

Ohne einen Addierer besteht keine direkte Möglichkeit, das Verzerrsignal zum Eingangssignal zu addieren. Falls der Analog-Digital-Konverter über einen differenziellen Eingang verfügt und das Eingangssignal massebezogen ist, kann jedoch eine Subtraktion erfolgen, indem das Eingangssignal an den positiven Eingang und das Verzerrsignal an den negativen Eingang gelegt wird, oder umgekehrt. Die Subtraktion ist der Addition hier äquivalent, weil das Vorzeichen des Verzerrsignals frei gewählt werden kann. Diese einfache Teillösung (A1) für das Additionsproblem ist kostengünstig zu realisieren. Sie ist jedoch insbesondere dann problematisch, wenn ein integrierter Analog-Digital-Konverter bereits einen massebezogenen Eingang hat, d.h. der negative Eingang ist intern fest mit Massepotential verbunden.

Fast alle Analog-Digital-Konverter weisen dagegen einen Referenzeingang auf, an dem eine Gleichspannung anzuschließen ist, die als Bezugsgröße für die Konversion durch den Analog-Digital-Konverter dient. Dieser Eingang muss für die prinzipielle Funktion eines integrierten Analog-Digital-Konverters nicht zwingend nach außen geführt werden, eine interne Verbindung von der Spannungsversorgung zum Referenzeingang würde dabei typischerweise ausreichen. Tatsächlich ist der Referenzeingang jedoch in vielen Fällen von außen zugänglich, selbst wenn der Hersteller vorschreibt, die Versorgungsspannung dort anzulegen. Durch die Trennung der Anschlüsse kann nämlich das EMV-Verhalten des Systems verbessert werden. Es besteht somit die Möglichkeit, dort eine Spannung anzulegen, welche die Summe aus einer regulären Referenz-Gleichspannung und einem Verzerrsignal ist (Teillösung A2) . Diese Lösung ist nahezu universell verwendbar hinsichtlich der verlangten Eigenschaften des Analog-Digital-Konverters bzw. Mikrocontrollers, jedoch nicht bezüglich der verarbeiteten Signale, denn mathematisch betrachtet wird im Analog-Digital-Konverter das Eingangssignal durch die Referenzspannung dividiert, um eine Zahl zu erhalten, welche ganzzahlig gerundet den Ausgangswert repräsentiert. Wird nun ein Verzerrsignal an den Referenzeingang angeschlossen, handelt es sich nicht mehr um die bekannte Operation "Dithering", d.h. Addition einer Hilfsgröße zum Eingangssignal. Stattdessen stellt die Addition der Hilfsgröße zu einer dritten Größe (Referenzspannung) und Division des Eingangssignals durch diese Summe eine neuartige Operation mit etwas anderen technischen Eigenschaften dar.

Das Verzerrsignal kann für diese neuartige Operation vorzugsweise nach dem gleichen Kriterium gewählt werden wie beim konventionellen Dithering: Der Ausgang des Analog-Digital-Konverters soll bei Verwendung einer Gleichspannung als Eingangssignal wenige LSB überstreichen, d.h. zwischen wenigen benachbarten Werten schwanken. Über die Größe des Verzerrsignals im Verhältnis zum Eingangssignal kann keine allgemeingültige Aussage getroffen werden, weil Analog-Digital-Konverter ganz unterschiedlich große Referenzsignale im Vergleich zum Eingangsspannungsbereich aufweisen.

Der Unterschied zwischen dem konventionellen Dithering und der neuartigen Operation besteht insbesondere darin, dass die Division nicht im gesamten Eingangsspannungsbereich des Analog-Digital-Konverters gute Ergebnisse liefert. In typischen Anwendungsfällen werden die Eigenschaften des konventionellen Ditherings bei großen Eingangssignalen, die den Eingangsspannungsbereich des Analog-Digital-Konverters ausschöpfen, annähernd erreicht, während der Nutzen bei kleinem Eingangssignal immer geringer wird, bis schließlich bei Signal nahe null eine schädliche Wirkung eintritt. Die Ursache dafür ist, dass das Verzerrsignal dann groß gegenüber dem Eingangssignal wird. Die neuartige Operation ist somit insbesondere geeignet für Systeme, bei denen keine Signale mit geringer Amplitude auftreten. Dies ist bei vielen Sensorsystemen der Fall, die eine Zwischengröße zur Übertragung der Sensorinformation nutzen, wie etwa bei Sensoren für Weg oder Winkel, die nach magnetischen Wirkprinzipien arbeiten. Die Messgröße moduliert bei vielen dieser Sensoren ein Magnetfeld, wobei sehr geringe Amplituden des Magnetfelds wegen des dann schlechten Signal-zu-Rausch-Verhältnisses ohnehin unerwünscht sind. Insgesamt erreicht die neuartige Operation die Ergebnisse des konventionellen Ditherings in vielen Fällen nicht vollständig. Ihr Nutzen lässt sich aber aus folgendem Vergleich ableiten, der für die eingangs beschriebenen Frequenz- und Bandbreitenverhältnisse typisch ist. Danach bestehen drei konstruktive Alternativen für ein typisches Sensorsystem:

1. kein Dithering, 10-Bit-Auflösung, Basiskosten
2. konventionelles Dithering, 14-Bit-Auflösung, deutlich erhöhte Kosten
3. Dithering nach Teillösung A2, 13-Bit-Auflösung, minimal erhöhte Kosten

Der Vergleich macht deutlich, dass alle Systeme, denen die Verbesserung zum Beispiel auf 13 Bit ausreicht, von der Einsparung des Addierers (d.h. in der Regel eines Operationsverstärker-ICs) profitieren können.

Eine weitere Möglichkeit, das Dithering ohne Addierer durchzuführen, besteht darin, unterschiedlich Arten der Kopplung des Verzerrsignals und des Eingangssignals an dem Analog-Digital-Konverter vorzusehen (Teillösung A3) . Diese Lösung ist ebenfalls sehr kostengünstig durchzuführen und hat den Vorteil, für den gesamten Bereich von Eingangsamplituden nutzbar zu sein, jedoch müssen die Frequenzen besonders betrachtet werden.

Die unterschiedlichen Arten der Kopplung sind insbesondere Gleichspannungskopplung (auch galvanische Kopplung genannt, d.h. lediglich Widerstände zwischen gekoppelten Knoten) und Wechselspannungskopplung (d.h. Kapazitäten zwischen den gekoppelten Knoten, allgemein auch Induktivitäten, wobei typischerweise Kapazitäten bevorzugt werden). Ein Knoten einer elektronischen Schaltung, hier der Eingang des Analog-Digital-Konverters, kann eine Gleichspannungskopplung zu einer Quelle und eine Wechselspannungskopplung zu einer anderen Quelle aufweisen. Die Quellen unterscheiden sich dann in dem Frequenzbereich, in dem sie den überwiegenden Beitrag zur Eingangsspannung des Analog-Digital-Konverters liefern. Diese Frequenzbereiche der beiden Quellen müssen hinreichend voneinander getrennt sein, damit die gewünschte Wirkung eintritt. Berücksichtigt man, dass das Verzerrsignal typischerweise eine Wechselspannung ist, so gibt es beispielsweise folgende Möglichkeiten:

1. Die Messgröße enthält Komponenten bis zur Frequenz null. Dann wird dafür vorteilhaft eine Gleichspannungskopplung verwendet. Das höherfrequente Verzerrsignal wird durch Wechselspannungskopplung, insbesondere kapazitive Kopplung, vorteilhaft hinzugefügt.

2. Die Messgröße weist eine untere Frequenzgrenze auf, die sich deutlich von null unterscheidet. Dies tritt insbesondere in Systemen auf, bei denen ein Modulationsverfahren verwendet wird. Die Kopplung der hochfrequenten Messgröße kann durch Wechselspannungskopplung, insbesondere kapazitive Kopplung, erfolgen. Das niederfrequente Verzerrsignal kann durch Gleichspannungskopplung hinzugefügt werden. Die digitale Signalverarbeitung ist in diesem Fall vorzugsweise keine einfache Mittelwertbildung, sondern es wird vorzugsweise eine Demodulation des Wechselspannungssignals am Eingang erfolgen. Hierfür können diverse Algorithmen verwendet werden.

Eine weitere Möglichkeit ist es, die Spannung des Verzerrsignals und die einer zu messenden Signalquelle durch eine Reihenschaltung an einem einzelnen Eingang des Analog-Digital-Konverters zu addieren. Hierzu weist vorzugsweise zumindest eine der Quellen die Eigenschaft auf, nicht massebezogen zu sein. Dies ist für den Fall einer Signalquelle insbesondere möglich bei Sensoren, welche eine Spannungsquelle mit gegenüber der restlichen Schaltung potentialfreien Anschlüssen darstellen, d.h. die Anschlüsse weisen kein festgelegtes Potential gegenüber dieser Schaltung auf. Daher können solche Signalquellen mit einer massebezogenen Quelle des Verzerrsignals in Reihe geschaltet werden.

Dies trifft insbesondere auf induktive Sensoren zu, die nach dem transformatorischen Prinzip arbeiten, bei denen also eine oder mehrere Induktivitäten vorgesehen sind, die bestromt werden (primäre Induktivität), um ein Magnetfeld zu erzeugen, sowie eine oder mehrere andere, magnetisch gekoppelte Induktivitäten (sekundäre Induktivitäten), an denen die von der Messgröße abhängende, das Magnetfeld beeinflussende induzierte Spannung gemessen wird (beispielsweise als Messinduktivitäten bezeichnet).

Besonders vorteilhaft ist ein Aufbau mit mehreren sekundären Induktivitäten bzw. mehreren Messinduktivitäten, wenn diese jeweils an einem Pol miteinander verbunden werden, wobei die Messung der induzierten Spannung in keiner Weise eingeschränkt wird. Dann kann an dem einen Pol, der alle Induktivitäten verbindet, eine einzelne Spannungsquelle des Verzerrsignals angeschlossen werden, während der andere Pol jeder sekundären Induktivität bzw. Messinduktivität für eine Messung der jeweiligen induzierten Spannung zur Verfügung steht. Bei diesem Pol kann es sich beispielsweise um den weiter oben bereits erwähnten Potentialpunkt und/oder den Verzerrsignal-Referenzpunkt handeln.

Es kann des Weiteren ein integrierter Generator vorgesehen sein. Fast jeder Mikrokontroller verfügt über einen oder mehrere Timer oder Zähler, die mit seinen digitalen Ausgängen zusammenwirken können. Die möglichen Arten der Zusammenwirkung unterscheiden sich im Einzelnen. Eine typische Funktion, die sehr häufig zu finden ist, besteht darin, dass bei jedem Überlauf des Zählers ein Flip-Flop seinen Zustand wechselt, das mit einem digitalen Ausgang verbunden ist. Daraufhin wird der Zähler mit einem Startwert neu geladen und der Vorgang beginnt von vorn. Im Ergebnis kann mit dieser Anordnung eine Rechteckspannung mit programmierbarer Frequenz erzeugt werden. Die erzielbaren Frequenzen liegen beispielsweise im Bereich von < 1 Hz bis > 1 MHz. Da der Zähler vom Takt des Taktoszillators des Mikrokontrollers gesteuert wird, lässt sich die Rechteckspannung gut mit dem ADC synchronisieren, für den das gleiche gilt. Somit lässt sich die Bedingung der Synchronität leicht mit den Mitteln des Mikrokontrollers erfüllen. Allerdings ist eine Rechteckspannung als Verzerrsignal häufig nicht optimal, weil die Wirkung des Ditherings ja gerade darauf beruht, dass das Verzerrsignal viele unterschiedliche Werte annimmt, damit bei der Mittelwertbildung der Ausgangswerte des Analog-Digital-Konverters schon bei geringer Änderung des Eingangssignals eine veränderte Verteilung der Ausgangswerte entsteht. Eine Rechteckspannung weist nur zwei Werte auf und kann dies typischerweise nicht leisten. Außerdem ist die Amplitude der Rechteckspannung häufig zu hoch, denn der digitale Ausgang hat seine stabilen Werte im Regelfall in der Nähe der positiven und negativen Versorgungsspannung.

Die Rechteckspannung wird daher bevorzugt umgeformt und abgeschwächt, damit unter Erhaltung der Synchronität innerhalb jeder Periode viele unterschiedliche Werte (Zwischenwerte) angenommen werden. Dazu können beispielsweise ein Filter bzw. Integrator und/oder ein Spannungsteiler bzw. Vorwiderstand verwendet werden. Aktive Filter kommen dabei vorzugsweise nicht in Betracht, weil dies die Kosten erhöhen würde. Stattdessen werden bevorzugt lediglich passive RC-Netzwerke zur Filterung und zur Anpassung von Amplitude und ggf. Mittelwert verwendet. Der Verzicht auf aktive Filter wirkt zunächst wie ein Nachteil, weil exakte Dreieck- oder Sägezahnsignale so nicht erzeugt werden können. Eine Untersuchung des Zusammenhangs zwischen Kurvenform des Verzerrsignals und Wirksamkeit des Ditherings hat jedoch gezeigt, dass eine gleichmäßige Verteilung der Spannungswerte nicht erforderlich ist. Das Dithering kann also auch mit der periodischen Abfolge von Abschnitten der e-Funktion erfolgen, welche sie sich am Ausgang eines mit einem Rechtecksignal beaufschlagten RC-Gliedes als Filter einstellt.

Für eine vorteilhafte Auslegung soll darauf geachtet werden, dass die Ausgangsspannung sich zu aufeinanderfolgenden Abtastzeitpunkten hinreichend unterscheidet. Als hinreichend gilt insbesondere die Erfüllung des Kriteriums für die Überstreichung mehrerer benachbarter Ausgangswerte des Analog-Digital-Konverters im Messintervall. Jedes Zeitintervall sollte an der Erzeugung dieser Verteilung von Ausgangswerten beteiligt sein, sonst findet in diesem Intervall effektiv kein Dithering statt. In diesem Fall würde das betreffende System zwar noch gültige Werte messen, die Auflösung bliebe aber unter den gezeigten Möglichkeiten.

Jede Implementierung der Problemlösung besteht vorzugsweise aus einem Generatornetzwerk und einer der Teillösungen A1, A2 oder A3 bzw. der eben beschriebenen Lösung. Ein Sensorsystem, das über mehrere Messkanäle verfügt, kann auch mehrere solcher Anordnungen enthalten, wobei jeder Messkanal eine eigenständige Beschaltung aufweisen oder einzelne Teile mit anderen Messkanälen gemeinsam nutzen kann. In diesem Fall sind bevorzugt Schalter vorzusehen, die die notwendigen Verbindungen herstellen bzw. trennen. Ein typisches Beispiel ist die Verwendung eines Multiplexers am Eingang eines ADC, der damit mehreren Kanälen zur Verfügung steht.

Des Weiteren kann eine Signalverarbeitung und Behandlung von Wechselspannungssignalen vorgesehen sein.

Bei der Betrachtung von Dithering nach dem Stand der Technik wird - oft stillschweigend - vorausgesetzt, dass das zu messende Signal innerhalb eines Messintervalls konstant ist. Das Messintervall ist die Zeit, aus der die Einzelmessungen stammen, die zu einem hochauflösenden Ergebnis vereinigt werden. Stillschweigend erfolgt die Annahme des konstanten Signals dadurch, dass die Mittelwertbildung im Messintervall verwendet wird, denn die Mittelwertbildung führt zwar auch bei einer Signaländerung zu einer Erhöhung der Auflösung des Ergebnisses, jedoch auch zu einer Verfälschung des Ergebnisses gegenüber dem Signal. Grund ist die Wirkung der Mittelwertbildung als Tiefpass, d.h. höherfrequente Anteile im Signal werden unterdrückt.

Ändert sich das zu messende Signal sehr schnell, wie es z.B. bei induktiven Sensoren häufig der Fall ist, so kann mit den ADC in Mikrokontrollern kaum noch Dithering nach dem Stand der Technik vorgenommen werden, weil die Änderung des Signals bereits im Zeitintervall zwischen zwei mit höchster Abtastrate aufeinanderfolgenden Samples hoch und keinesfalls vernachlässigbar ist. Beträgt z.B. die maximale Abtastrate 200 kHz, so müssen für ein Messintervall aus z.B. 50 Samples Änderungen des Signals innerhalb von 50 · 1/200 kHz = 250 $\mu$s vernachlässigbar sein. Setzt man nun für 'vernachlässigbar' 1/20tel einer Signalperiode an, so erhält man für die maximale Frequenz, für die das Dithering unter den angegebenen Bedingungen stattfinden kann: 1/250 $\mu$s · 1/20 = 200 Hz. Die Festsetzung von 1/20tel einer Signalperiode mag willkürlich niedrig erscheinen, jedoch ändert sich ein Signal wie etwa ein Sinus bereits in einer halben Signalperiode um maximal das doppelte der Amplitude. In einem Zehntel dieser Zeitspanne sind das im Mittel 20 % der Amplitude, deutlich mehr am Nulldurchgang. Diese Werte als vernachlässigbar zu betrachten, kann für manche Anwendungen bereits problematisch sein. Dithering in der bekannten Form ist für die Signalverarbeitung mit einfachen Mikrokontrollern somit auf geringe Signalfrequenzen beschränkt.

Umgekehrt sind induktive Sensoren gerade bei höheren Arbeitsfrequenzen besonders effektiv, weil die induzierte Spannung proportional zur Frequenz ist:

$$U = d\Phi/dt, \quad \Phi(t) = \Phi0 \ sin(\omega t) \Rightarrow U = \Phi0 \ \omega \ sin(\omega t)$$

Für einen gegebenen sinusförmigen magnetischen Wechselfluss mit der Amplitude $\Phi0$ ist die zu messende induzierte Spannungsamplitude proportional zur Kreisfrequenz $\omega$. Soll ein induktiver Sensor mit kostengünstigen und kleinen Induktivitäten, insbesondere planaren, d.h. leiterplattenintegrierten Induktivitäten, aufgebaut werden, so sind Arbeitsfrequenzen von 500 kHz oder mehr anzustreben, weil nur dann eine attraktive Kombination aus Kosten, Abmessungen und Signalamplitude erreicht wird. Zwischen dem Frequenzbereich, der dem Dithering nach dem Stand der Technik zugänglich ist, und dem Zielfrequenzbereich für induktive Sensoren klafft daher eine Lücke von mehr als drei Zehnerpotenzen. Diese Lücke kann keinesfalls geschlossen werden, indem alle Parameter, die an der Rechnung beteiligt sind, auf etwas günstigere Werte getrimmt werden.

Das Problem kann gelöst und ein induktiver Sensor mit Dithering aus einem einfachen Mikrokontroller gebaut werden, indem Dithering ohne die nach dem Stand der Technik verwendete Mittelwertbildung implementiert wird. Anders ausgedrückt, indem eine Operation implementiert wird, die eine dem Dithering äquivalente Wirkung ohne Mittelwertbildung erlaubt. Dazu werden beispielsweise die folgenden Schritte ausgeführt:

Wenn die gewählte Arbeits-Frequenz so hoch ist, dass die Nyquist-Frequenz des ADC auch bei maximal möglicher Abtastrate darunter liegt, so wird Unterabtastung gezielt eingesetzt. Dabei erscheint das Signal des Stimulus durch Aliasing bei einer Frequenz unterhalb der jeweiligen Nyquist-Frequenz am Ausgang des ADC; Aliasing ist hier also keine Störung oder ein Ausschlusskriterium, sondern erwünscht. Im weiteren Verlauf wird nun eine gemessene Frequenz oder ein gemessenes Signal erörtert. Damit ist die Arbeitsfrequenz bzw. ein Signal bei dieser Frequenz gemeint, wenn keine Unterabtastung notwendig war, oder die durch Aliasing aufgetretene Frequenz bzw. ein Signal bei dieser Frequenz, wenn Unterabtastung benutzt wurde.

Um das gewünschte Ergebnis zu erhalten, erfolgt anstelle der Mittelwertbildung eine spektrale Auswertung der gemessenen Samples im Messintervall. Dazu ist es besonders vorteilhaft, wenn eine ganzzahlige Anzahl von Perioden des gemessenen Signals im Messintervall vorhanden ist. Die Anzahl der Samples im Messintervall, die Abtastrate und die Arbeitsfrequenz sollten so gewählt werden, dass diese Bedingung erfüllt ist. Dadurch wird erreicht, dass bei kontinuierlicher Messung die Phasenlage des gemessenen Signals in jedem Messintervall gleich ist und innerhalb eines Messintervalls kein Phasensprung zwischen Anfang und Ende besteht.

Die spektrale Auswertung erfolgt vorzugsweise durch DFT (Diskrete Fourier-Transformation) oder eine vergleichbare Operation, mit der ein Spektrum erzeugt werden kann, das die Amplituden des gemessenen Signals für diskrete Werte der Frequenz zeigt. Diese Amplituden können dabei als reelle oder komplexe Werte berechnet werden. Komplexe Werte können als Real- und Imaginärteile oder Betrag und Phase dargestellt werden. Zur Implementierung einer solchen Operation stehen Algorithmen wie z.B. FFT ("Fast Fourier Transformation") oder der Goertzel-Filter zur Verfügung, der kein vollständiges Spektrum bestimmt, sondern nur die Amplitude für eine Frequenz.

Zur Bestimmung der Amplitude bei der Arbeitsfrequenz durch spektrale Auswertung ist es ausreichend, wenn sich innerhalb des Messintervalls diese Amplitude nur vernachlässigbar ändert. Die Amplitudenänderung jedoch, die durch die Messgröße bestimmt wird, ist abhängig von der Anwendung und erfolgt wesentlich langsamer als die Änderung des Momentanwerts des Signals bei der Arbeitsfrequenz. Die beiden Änderungsraten werden durch die spektrale Auswertung entkoppelt, so dass die Arbeitsfrequenz keine Grenze mehr für die Wahl des Messintervalls darstellt oder umgekehrt. Alle Aussagen, die oben zum Zusammenhang zwischen Arbeitsfrequenz und Messintervall gemacht wurden, gelten nun nur noch für die höchste Frequenz der Messgröße.

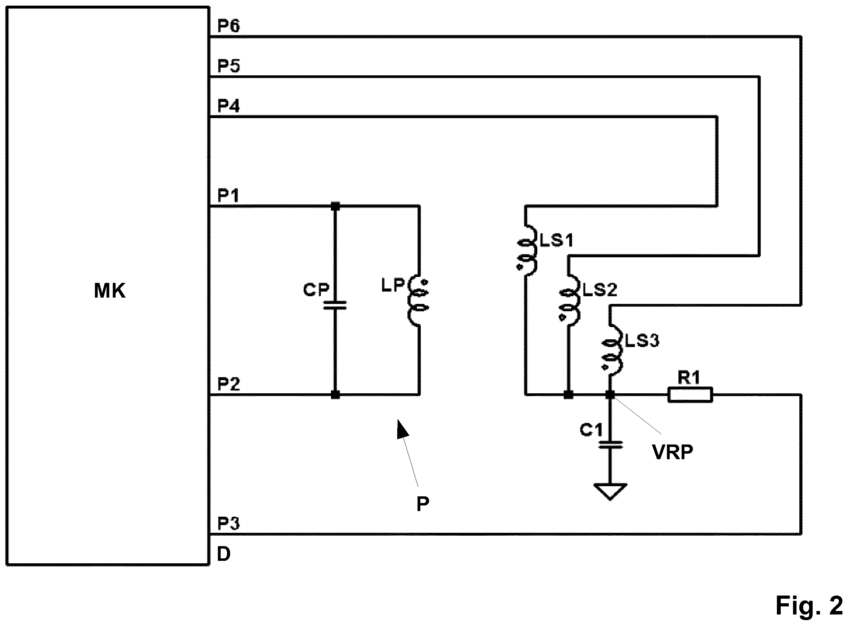

Der Wert der Messgröße, die das Magnetfeld bei der Arbeits-frequenz beeinflusst, wird schließlich vorzugsweise aus der Amplitude bei der gemessenen Frequenz berechnet. Im einfachsten Fall sind beide proportional. Sie können jedoch auch durch eine beliebige monotone mathematische Funktion verknüpft sein. Bei mehreren Kanälen, d.h. mehreren sekundären Induktivitäten eines Sensors wie in Fig. 2 hat die Funktion die gleiche Anzahl von Variablen wie Kanäle vorhanden sind. Die mehreren Kanäle lassen sich besonders vorteilhaft für differentielle oder ratiometrische Messungen nutzen.

Das Dithering selbst erfolgt vorzugsweise dadurch, dass das Verzerrsignal, wie bei den anderen Methoden auch, zum Signal bei der Arbeitsfrequenz addiert wird, besonders bevorzugt wie dies in Fig. 2 dargestellt ist.

Dort wird der der Portpin P3 genutzt, um eine Rechteckspannung anzulegen, die durch R1 und C1 zu einer ungefähren Dreieckspannung sehr kleiner Amplitude geformt wird, die am gemeinsamen Knoten der sekundären Induktivitäten LS1 bis LS3 wirksam wird. Die dazugehörige Zeitkonstante RC sollte daher groß gegenüber der Periode der Spannung an P3 gewählt werden. Diese Periode sollte so hoch gewählt werden, dass möglichst viele verschiedene Werte des Verzerrsignals im Messintervall auftreten, das Verzerrsignal sich also im Messintervall wenig bis gar nicht wiederholt. Da das Signal periodisch sein soll, kann dies vorteilhaft erreicht werden durch eine ganzzahlige Anzahl von Halbschwingungen der Spannung an P3 im Messintervall, die vorzugsweise eins oder zwei beträgt. Dies ist aber nicht zwingend, da nicht notwendigerweise der gesamte Arbeitszyklus des Sensors vom Messintervall eingenommen wird. Das Messintervall kann daher z.B. auch nur einen Teil einer Halbschwingung an P3 umfassen. In jedem Fall ist das Ziel der Versorgung des gemeinsamen Knotens der sekundären Induktivitäten LS1 bis LS3 mit einer Wechselspannung, dass verschiedene Samples in jedem Messintervall in deterministischer Weise verschiedene Werte dieser Wechselspannung erfahren, wodurch die Spannung jeweils um Bruchteile eines LSB verschoben wird. Dadurch wird der Effekt des Dithering erreicht.

Es sei erwähnt, dass die DFT eine Transformation ist, bei der das Ergebnis jedes Punktes des Spektrums in gleicher Weise von allen Punkten der Eingangsfolge abhängt. Daher erfolgt eine Art Mittelwertbildung der Punkte des Spektrums, wenn sich eine Amplitude während des Intervalls der Eingangsfolge ändert. In diesem Sinne erfolgt die hier vorgestellte Lösung nicht ohne Mittelwertbildung, sondern eine einfache Bildung des arithmetischen Mittels wurde durch eine andersartige Mittelwertbildung ersetzt.

Es sei darauf hingewiesen, dass vom Erfinder der vorliegenden Anmeldung insbesondere erkannt wurde, dass die Verwendung von induktiven Sensoren in Verbindung mit Dithering für hochfrequente Wechselspannungen und der dazugehörigen Signalverarbeitung von hoher technischer und kommerzieller Bedeutung ist. Beispielhafte Anwendungen liegen in der Messung von Weg bzw. Position und Winkel, besonders in Kraftfahrzeugen. Ein Beispiel ist die Messung der Position des Druckkolbens im Hauptbremszylinder eines Pkw.

Nachfolgend werden weitere mögliche Merkmale strukturiert wiedergegeben, wobei diese Merkmale beliebig untereinander und mit den anderen hierin beschriebenen Merkmalen kombiniert werden können.

Der Analog-Digital-Konverter kann insbesondere als Bestandteil eines Mikrocontrollers ausgebildet sein. Ebenfalls kann der Verzerrsignal-Generator Bestandteil des Mikrocontrollers sein. Dies ermöglicht eine besonders kompakte und vorteilhafte Ausführung.

Der Verzerrsignal-Generator kann beispielsweise mittels eines digitalen Ausgangs des Mikrocontrollers implementiert sein, welcher den Verzerrsignal-Ausgang bildet.

Der Analog-Digital-Konverter kann einen differenziellen Eingang aufweisen, wobei der Verzerrsignal-Ausgang mit einem Anschluss des differenziellen Eingangs gekoppelt ist.

Zwischen dem Verzerrsignal-Ausgang und einem Referenzpotential, vorzugsweise Masse, kann ein Spannungsteiler angeschlossen sein, wobei der Anschluss des differenziellen Eingangs an einem Ausgang des Spannungsteilers angeschlossen ist.

Zwischen dem Anschluss des differenziellen Eingangs und dem Referenzpotential kann ein Kondensator angeschlossen sein, welcher vorzugsweise zumindest einen Widerstand des Spannungsteilers überbrückt.

Der Analog-Digital-Konverter kann zusätzlich zum Signaleingang einen Referenzeingang aufweisen, wobei der Verzerrsignal-Ausgang mit dem Referenzeingang gekoppelt ist.

Zwischen dem Verzerrsignal-Ausgang und einem Referenzpotential, vorzugsweise einem positiven Potential, kann ein Spannungsteiler angeschlossen sein, wobei der Referenzeingang an einem Ausgang des Spannungsteilers angeschlossen ist.

Zwischen dem Referenzeingang und dem Referenzpotential kann ein Kondensator angeschlossen sein, welcher vorzugsweise zumindest einen Widerstand des Spannungsteilers überbrückt.

Der Verzerrsignal-Ausgang und ein das Signal liefernder Signalanschluss können mit dem Signaleingang gekoppelt sein.

Der Verzerrsignal-Ausgang kann mit dem Signaleingang gleichspannungsgekoppelt sein, vorzugsweise galvanisch gekoppelt sein, und der Signalanschluss kann mit dem Signaleingang wechselspannungsgekoppelt sein, vorzugsweise kapazitiv gekoppelt sein.

Zwischen dem Verzerrsignal-Ausgang und dem Referenzpotential, vorzugsweise Masse, kann ein Spannungsteiler angeschlossen sein, wobei der Signaleingang an einem Ausgang des Spannungsteilers angeschlossen ist.

Ein Widerstand des Spannungsteilers, welcher zwischen dem Verzerrsignal-Ausgang und dem Ausgang des Spannungsteilers angeschlossen ist, kann größer sein als ein Widerstand, welcher zwischen dem Ausgang des Spannungsteilers und dem Referenzpotential angeschlossen ist.

Bei dem Mikrocontroller kann es sich insbesondere um die elektronische Steuerungseinheit handeln.

Der Parallelschwingkreis kann an einem ersten Portpin und an einem zweiten Portpin der elektronischen Steuerungseinheit angeschlossen sein, wobei der zweite Portpin mit einem zum ersten Portpin invertierten Takt versorgt wird.

Der Parallelschwingkreis kann parallel zum ersten Portpin mit einer Anzahl weiterer erster Portpins verbunden sein, welche zum ersten Portpin synchron geschaltet werden. Der Parallelschwingkreis kann auch parallel zum zweiten Portpin mit einer Anzahl weiterer zweiter Portpins verbunden sein, welche zum zweiten Portpin synchron geschaltet werden.

Portpins, an welchen der Parallelschwingkreis angeschlossen ist, können vorteilhaft eine Push-Pull-Ausgangsstufe oder eine Tri-State-Ausgangsstufe aufweisen.

Die Anregungsfrequenz unterscheidet sich bevorzugt um maximal 25 %, besonders bevorzugt maximal 2 0%, weiter bevorzugt maximal 15 %, und noch weiter bevorzugt maximal 10 % von einer Resonanzfrequenz des Parallelschwingkreises.

Die Messinduktivität kann mit einem ersten Pol an einem Portpin der elektronischen Steuerungseinheit angeschlossen sein und mit einem zweiten Pol mit einem Potential verbunden sein, welches zumindest annähernd der halben Versorgungsspannung der elektronischen Steuerungseinheit entspricht.

Das Potential, welches zumindest annähernd der halben Versorgungsspannung der elektronischen Steuerungseinheit entspricht, kann insbesondere mittels eines Spannungsteilers erzeugt werden.

Das Potential, welches zumindest annähernd der halben Versorgungsspannung der elektronischen Steuerungseinheit entspricht, kann mittels eines Glättungskondensators erzeugt werden, wobei der Glättungskondensator mit einem ersten Pol mit einem Bezugspotential oder mit der Versorgungsspannung verbunden ist, und wobei ein zweiter Pol des Glättungskondensators über einen Widerstand mit einem Portpin der elektronischen Steuerungseinheit verbunden ist, welcher mit einem gepulsten Signal, insbesondere mit einem Signal mit vorgebbarem Tastverhältnis, beaufschlagt wird.

Die elektronische Steuerungseinheit kann vorzugsweise dazu konfiguriert sein, beim Einschalten zunächst den Glättungskondensator auf die zumindest annähernd halbe Versorgungsspannung aufzuladen, während Portpins, an welchen der Parallelschwingkreis angeschlossen ist, den gleichen Logikpegel aufweisen, um erst danach eine Anregung des Parallelschwingkreises zu beginnen.

Ein von den Messinduktivitäten erzeugtes Signal kann insbesondere mit einem Analog-Digital-Konverter der elektronischen Steuerungseinheit erfasst und unter Berücksichtigung von Aliasing dessen Kennwerte, insbesondere Amplitude, Phase, Realteil und/oder Imaginärteil, bestimmt werden, und zwar vorzugsweise bei der Anregungsfrequenz oder bei einem Alias der Anregungsfrequenz.

Aus einem in der elektronischen Steuerungseinheit erfassten Signal kann eine Frequenzkomponente bei einer Auswertungsfrequenz ermittelt werden, wobei die Auswertungsfrequenz insbesondere die Anregungsfrequenz oder ein Alias der Anregungsfrequenz ist.

Die Messinduktivität kann galvanisch oder magnetisch mit der ersten Induktivität gekoppelt sein.

Der Parallelschwingkreis weist vorzugsweise eine maximale Güte auf, welche durch Maximierung eines Werts von Vt * Vt / V0 erhalten wird, wobei Vt ein Verhältnis aus Spulenstrom und Zuleitungsstrom bei maximaler Abweichung der Kapazität und der ersten Induktivität von ihren jeweiligen Werten bei der Resonanzfrequenz des Parallelschwingkreises bezeichnet, und wobei V0 ein Verhältnis aus Spulenstrom und Zuleitungsstrom bei jeweiligen Werten von Kapazität und erster Induktivität bei der Resonanzfrequenz des Parallelschwingkreises bezeichnet.

Die Messgröße kann vorzugsweise durch Verändern einer Position eines magnetischen Kerns in der Messinduktivität, durch Verändern eines Abstands zwischen Messinduktivität und erster Induktivität und/oder durch Verändern einer Position eines magnetischen und leitfähigen, unmagnetischen und leitfähigen oder magnetischen und nicht leitfähigen Elements benachbart zur Messinduktivität und zur ersten Induktivität abgefühlt werden.

Die Vorrichtung kann eine, zwei, drei oder mehr als drei Messinduktivitäten aufweisen.

Ein magnetisches und leitfähiges Element kann beispielsweise aus Stahl sein. Ein unmagnetisches und leitfähiges Element kann beispielsweise aus Aluminium sein. Ein magnetisches und nicht leitfähiges Element kann beispielsweise aus Ferrit sein.

Die elektronische Steuerungseinheit kann beispielsweise als Anwendungsspezifischer Integrierter Schaltkreis, ASIC, und/oder als Anwendungsspezifisches Standardprodukt, ASSP, ausgebildet sein.

Die elektronische Steuerungseinheit kann beispielsweise ein Direkte-Digitale-Synthese(DDS)-Modul aufweisen, um die Anregungsfrequenz zu erzeugen.

Die elektronische Steuerungseinheit kann dazu konfiguriert sein, durch Verändern der Anregungsfrequenz eine Resonanzfrequenz des Parallelschwingkreises zu ermitteln und die Anregungsfrequenz identisch zur Resonanzfrequenz oder benachbart zur Resonanzfrequenz einzustellen.

Die elektronische Steuerungseinheit kann dazu konfiguriert sein, eine erfolgte oder bevorstehende Überschreitung eines maximalen Pegels an einem Portpin zu erkennen, und ansprechend darauf die Anregungsfrequenz zu ändern, insbesondere weiter von der Resonanzfrequenz des Parallelschwingkreises zu beabstanden.

Die elektronische Steuerungseinheit kann dazu konfiguriert sein, eine Störunterdrückung auszuführen, wozu die Anregungsfrequenz kontinuierlich innerhalb eines Messintervalls variiert wird und/oder die Anregungsfrequenz innerhalb eines Messintervalls variiert wird und abhängig von der Anregungsfrequenz ein Signal-zu-Rausch-Verhältnis ermittelt wird, wobei nachfolgend die Anregungsfrequenz auf einen Wert mit maximalem Signal-zu-Rausch-Verhältnis eingestellt wird.

Die elektronische Steuerungseinheit kann zumindest einen Analogmultiplizierer aufweisen, welcher an einen Portpin zum Anschluss der Messinduktivität und an ein Signalmodul angeschlossen ist, wobei das Signalmodul ein oszillierendes Signal mit einer Frequenz mit definiertem, insbesondere geringem Abstand zur Anregungsfrequenz liefert, wobei das Signalmodul vorzugsweise als Direkte-Digitale-Synthese(DDS)-Modul ausgebildet ist, und wobei ein Ausgangssignal des Analogmultiplizierers, insbesondere ein Differenzsignal, in der elektronischen Steuerungseinheit zur Ermittlung der Messgröße weiterverwendet wird.

Weitere Merkmale und Vorteile wird der Fachmann den nachfolgend mit Bezug auf die beigefügte Zeichnung beschriebenen Ausführungsbeispielen entnehmen. Dabei zeigen:

    Fig. 1: einen Mikrocontroller mit Außenbeschaltung,
    Fig. 2: eine Vorrichtung zum Messen einer Messgröße, und
    Fig. 3: Signalverläufe in Abhängigkeit von der Zeit.

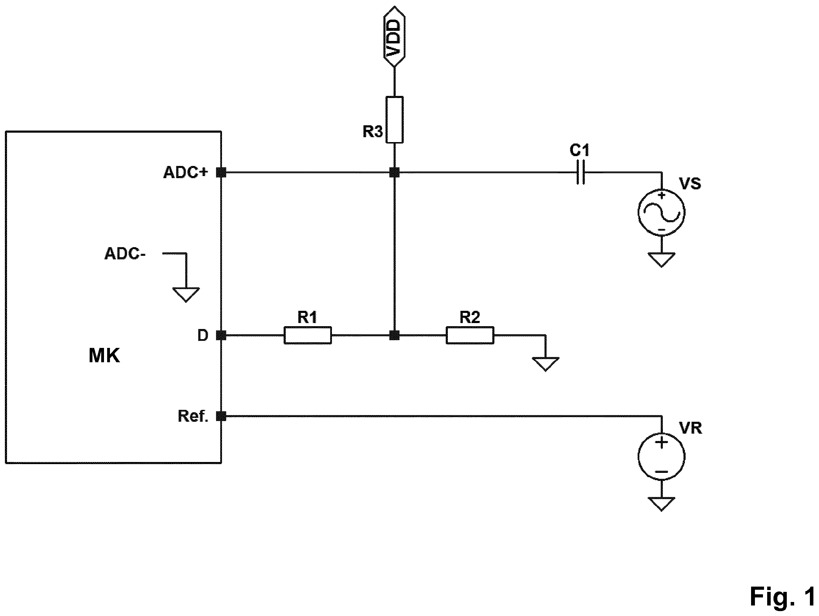

Figur 1 zeigt einen Mikrocontroller MK mit einer Außenbeschaltung. Der Mikrocontroller MK weist einen Referenzeingang Ref. auf, welcher auf einer definierten Spannung VR liegt. Der Mikrocontroller MK weist einen Verzerrsignal-Ausgang D auf, welcher dazu ausgebildet ist, ein Verzerrsignal auszugeben. Der Verzerrsignal-Ausgang D ist mit einem Spannungsteiler verbunden, welcher aus einem ersten Widerstand R1 und einem zweiten Widerstand R2 gebildet wird, welche seriell zueinander geschaltet sind und gegenüberliegend zum Verzerrsignal-Ausgang D auf Masse geschaltet sind.

Der Mikrocontroller MK weist des Weiteren einen Analog-Digital-Konverter auf, welcher einen Signaleingang ADC+ aufweist. Der Analog-Digital-Konverter ist im Mikrocontroller MK integriert und weist zusätzlich zum Signaleingang ADC+ ferner einen negativen Eingang ADC- auf, welcher jedoch hier von außen nicht zugänglich ist und Mikrocontroller-intern mit Masse verbunden ist. Die am Referenzeingang Ref. anliegende Spannung, welche von einer konventionell am Referenzeingang Ref. angeschlossenen Gleichspannungsquelle geliefert wird, ist eine Referenzspannung des Analog-Digital-Konverters.

Die Außenbeschaltung, welche in Fig. 1 gezeigt ist, ist dazu ausgebildet, eine Signalspannung VS zu messen. Diese ist vorliegend als Wechselspannung dargestellt, kann jedoch grundsätzlich eine Ausgangsspannung eines Sensors oder einer anderen zu überwachenden oder zu messenden Einheit sein.

Die Signalspannung VS wird kapazitiv über einen Kondensator C1 an den positiven Signaleingang ADC+ des Analog-Digital-Konverters gekoppelt. Daher kann nur der Wechselspannungsanteil von VS auf den Analog-Digital-Konverter wirken, und auch nur dieser gemessen werden. Der Signaleingang ADC+ ist ferner direkt, also galvanisch mit einem Punkt zwischen dem ersten Widerstand R1 und dem zweiten Widerstand R2 des weiter oben bereits beschriebenen Spannungsteilers verbunden, und ist ferner über einen dritten Widerstand R3 mit der Versorgungsspannung VDD verbunden. Das Netzwerk der drei Widerstände R1, R2, R3 bestimmt das Gleichspannungspotential am positiven Signaleingang ADC+. Der Verzerrsignal-Ausgang D liefert typischerweise ein Rechtecksignal, das dieses Potential beeinflusst. Die Frequenzbereiche der beiden Signale sollten für optimale Ergebnisse getrennt sein. Der erste Widerstand R1 wird üblicherweise sehr viel größer als der zweite Widerstand R2 und der dritte Widerstand R3 gewählt, weil die Spannung am Verzerrsignal-Ausgang D das Gleichspannungspotential des positiven Signaleingangs ADC+ nur um wenige Millivolt verschieben soll, während der zweite Widerstand R2 und der dritte Widerstand R3 das Potential im gesamten Versorgungsbereich einstellen.

Grundsätzlich ist mit der gezeigten Schaltung von Fig. 1 eine Messung einer Signalspannung VS bei Überlagerung mit einem Verzerrsignal möglich, welches durch den Verzerrsignal-Ausgang D bereitgestellt wird. Sowohl die Erzeugung des Verzerrsignals wie auch die Digitalisierung des überlagerten Signals erfolgen im Mikrocontroller MK. Die beiden Signale, also das Verzerrsignal und die zu messende Signalspannung, sind ohne aktive Komponenten, also insbesondere ohne Operationsverstärker und ohne aktive Addierschaltungen, an den Signaleingang ADC+ gekoppelt, wobei vorliegend eine galvanische Kopplung und eine kapazitive Kopplung verwendet werden.

Fig. 2 zeigt ein Ausführungsbeispiel, bei welchem das induktive System transformatorisch ausgeführt wird. Dabei ist ebenfalls ein Mikrocontroller MK vorgesehen, welcher eine Anzahl von sechs Portpins P1, P2, P3, P4, P5, P6 aufweist.

An den ersten und zweiten Portpins P1, P2 ist ein Parallelschwingkreis P angeschlossen, welcher eine erste Induktivität LP und eine Kapazität CP aufweist. Durch entsprechende Beschaltung der beiden ersten und zweiten Portpins P1, P2 mit einer Anregungsfrequenz, welche aus einem Takt des Mikrocontrollers MK abgeleitet wird, kann der Parallelschwingkreis P zu einer Schwingung angeregt werden.

Der dritte Portpin P3 des Mikrocontrollers MK fungiert als Verzerrsignal-Ausgang D. An dem dritten Portpin P3 ist ein Widerstand R1 angeschlossen, welcher an seinem gegenüberliegenden Pol einen Verzerrsignal-Referenzpunkt VRP bildet. Der Verzerrsignal-Referenzpunkt VRP ist zudem über einen Glättungskondensator C1 mit Masse verbunden. Durch das Anlegen eines gepulsten Signals am Verzerrsignal-Ausgang D kann die mittlere Spannung am Verzerrsignal-Referenzpunkt VRP sehr genau eingestellt werden. Insbesondere kann diese auf etwa die halbe Versorgungsspannung des Mikrocontrollers MK eingestellt werden, wobei deren Wechselspannungskomponente das Verzerrsignal sein kann. Das Verzerrsignal kann beispielsweise ein Sägezahnsignal oder ein Dreieckssignal sein.

An dem Verzerrsignal-Referenzpunkt VRP sind eine erste Messinduktivität LS1, eine zweite Messinduktivität LS2 und eine dritte Messinduktivität LS3 angeschlossen. Diese sind mit jeweils gegenüberliegenden Polen an dem vierten Portpin P4, dem fünften Portpin P5 und dem sechsten Portpin P6 angeschlossen. Diese dienen somit als Signaleingänge.

Zwischen der ersten Induktivität LP einerseits und den drei Messinduktivitäten LS1, LS2, LS3 andererseits besteht eine magnetische Kopplung, welche durch ein nicht dargestelltes Element beeinflusst werden kann. Dieses Element hängt von einer zu messenden Größe ab. Beispielsweise kann eine Stellung eines Kolbens in einem Bremszylinder überwacht werden, wobei die magnetische Kopplung zwischen der ersten Induktivität LP und den drei Messinduktivitäten LS1, LS2, LS3 von dieser Stellung abhängt. Somit kann die Stellung des Kolbens in dem Bremszylinder grundsätzlich durch Überwachung der drei Messinduktivitäten LS1, LS2, LS3 gemessen werden.

Die gezeigte Vorrichtung erlaubt insbesondere die Durchführung einer Messung unter Nutzung von Aliasing, wie dies weiter oben ausführlich beschrieben wurde. Auf eine Wiederholung wird an dieser Stelle verzichtet.

Es sei erwähnt, dass anstatt der Verbindung jeder der Messinduktivitäten LS1, LS2, LS3 mit einem jeweiligen Portpin P4, P5, P6 auch Messinduktivitäten in Reihe geschaltet werden können und an Verbindungsstellen zwischen Messinduktivitäten ein jeweiliger Spannungsabgriff erfolgen kann. Dadurch können jeweilige Spannungsabfälle über Messinduktivitäten durch Differenzbildung berechnet werden.

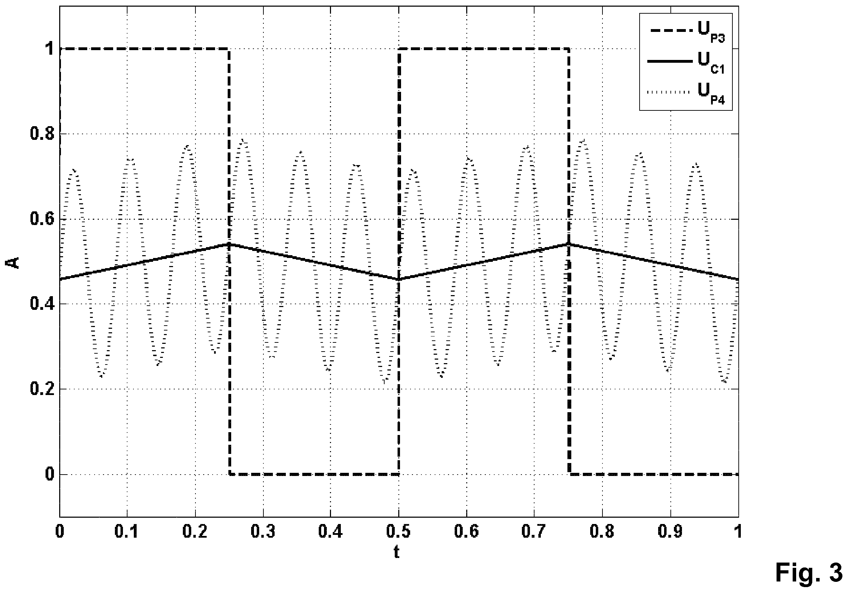

Fig. 3 zeigt drei Signalverläufe in Abhängigkeit von der Zeit. Die Zeit ist dabei in willkürlichen Einheiten von 0 bis 1 dargestellt. Auch die Amplitude ist in willkürlichen Einheiten von 0 bis 1 dargestellt. Die Zeit ist auf der horizontalen Achse dargestellt und mit t bezeichnet. Die Amplitude ist auf der vertikalen Achse dargestellt und mit A bezeichnet.

Fig. 3 zeigt zunächst das am Verzerrsignal-Ausgang D bzw. P3 anliegende Spannungssignal $U_{P3}$, welches eine Rechteckspannung ist. Des Weiteren ist das am Verzerrsignal-Referenzpunkt VRP bzw. am weiteren Kondensator C1 anliegende Signal $U_{C1}$ gezeigt. Dieses ist, wie Fig. 3 zu entnehmen ist, ein Dreiecksignal, welches um einen Mittelwert hin- und herschwingt. Es ist also eine Überlagerung eines konstanten Signals, welches zumindest in etwa oder auch vollständig der halben Versorgungsspannung des Mikrocontrollers MK entspricht, mit einem Verzerrsignal.

Des Weiteren ist beispielhaft das Signal dargestellt, welches am vierten Portpin P4 anliegt. Dieses ist mit $U_{P4}$ bezeichnet. Es ist zu sehen, dass dieses eine Sinuskurve darstellt und wesentlich schneller ist als die beiden anderen Signale. Dieses Signal kann zum Bestimmen der Messgröße verwendet werden. Wie gezeigt ist dem durch die Messgröße bestimmten Signal das Verzerrsignal überlagert.

Die zur Anmeldung gehörigen Ansprüche stellen keinen Verzicht auf die Erzielung weitergehenden Schutzes dar.

Es sei ferner darauf hingewiesen, dass Ausgestaltungen, Merkmale und Varianten der Erfindung, welche in den verschiedenen Ausführungen oder Ausführungsbeispielen beschriebenen und/oder in den Figuren gezeigt sind, beliebig untereinander kombinierbar sind. Einzelne oder mehrere Merkmale sind beliebig gegeneinander austauschbar. Hieraus entstehende Merkmalskombinationen sind als von der Offenbarung dieser Anmeldung mit abgedeckt zu verstehen.

**Patentansprüche**

1. Vorrichtung zum Messen einer Messgröße, aufweisend

   - eine erste Induktivität (LP),
   - zumindest eine Messinduktivität (LS1, LS2, LS3), welche zum Abfühlen der Messgröße ausgebildet ist und welche mit der ersten Induktivität (LP) gekoppelt ist,

- eine Kapazität (CP), welche mit der ersten Induktivität (LP) zu einem Parallelschwingkreis (P) verschaltet ist, und
- eine elektronische Steuerungseinheit (MK),
- wobei die elektronische Steuerungseinheit (MK) direkt mit dem Parallelschwingkreis (P) verbunden ist und dazu konfiguriert ist, den Parallelschwingkreis (P) mit einer Anregungsfrequenz oszillierend anzuregen, welche aus einem Takt der elektronischen Steuerungseinheit (MK) abgeleitet ist,
- wobei die elektronische Steuerungseinheit (MK) zumindest einen Analog-Digital-Konverter mit einem Signaleingang (P4, P5, P6) aufweist, welcher direkt mit der zumindest einen Messinduktivität (LS1, LS2, LS3) zum Aufnehmen eines Signals verbunden ist,
- wobei die elektronische Steuerungseinheit (MK) einen Verzerrsignal-Generator mit einem Verzerrsignal-Ausgang (P3, D) aufweist, wobei der Verzerrsignal-Generator dazu ausgebildet ist, an einem Verzerrsignal-Referenzpunkt (VRP) ein Verzerrsignal zu liefern,
- wobei der Verzerrsignal-Ausgang (D) ausschließlich mittels passiver Komponenten an den Analog-Digital-Konverter gekoppelt ist,
- wobei die elektronische Steuerungseinheit (MK) dazu konfiguriert ist, das Signal in Intervallen zu messen, wobei innerhalb jedes Intervalls eine Anzahl von Messwerten aufgenommen wird, und
- wobei die elektronische Steuerungseinheit (MK) dazu konfiguriert ist, eine Frequenzanalyse der Messwerte eines jeweiligen Intervalls durchzuführen und zumindest einen die Messgröße anzeigenden Kennwert des Signals bei einer Auswertungsfrequenz zu bestimmen.

2. Vorrichtung nach Anspruch 1,

- wobei die Messwerte um jeweilige Zeitdifferenzen beabstandet sind, wobei diese einer Unterabtastung des Signals entsprechen.

3. Vorrichtung nach einem der vorhergehenden Ansprüche,

- wobei die Auswertungsfrequenz die Anregungsfrequenz ist.

4. Vorrichtung nach einem der vorhergehenden Ansprüche,

- wobei die Auswertungsfrequenz ein Alias der Anregungsfrequenz ist, insbesondere unter Berücksichtigung von Aliasing.

5. Vorrichtung nach einem der vorhergehenden Ansprüche,

- wobei ein jeweiliges Messintervall eine ganzzahlige Anzahl von Perioden des Signals umfasst.

6. Vorrichtung nach einem der vorhergehenden Ansprüche,

- wobei ein jeweiliges Messintervall eine ganzzahlige Anzahl von Halbschwingungen des Verzerrsignals aufweist, vorzugsweise eine oder zwei Halbschwingungen.

7. Vorrichtung nach einem der vorhergehenden Ansprüche,

- wobei der Verzerrsignal-Ausgang (D) ohne aktive Komponenten, insbesondere ohne Operationsverstärker, an den Analog-Digital-Konverter gekoppelt ist.

8. Vorrichtung nach einem der vorhergehenden Ansprüche,

- wobei die Messinduktivitäten (LS1, LS2, LS3) mit einem jeweiligen ersten Pol an einem jeweiligen Signaleingang (P4, P5, P6) der elektronischen Steuerungseinheit (MK) angeschlossen sind, und mit einem jeweiligen zweiten Pol mit einem gemeinsamen Potentialpunkt verbunden sind.

9. Vorrichtung nach Anspruch 8,

- wobei an dem Potentialpunkt zumindest annähernd die halbe Versorgungsspannung der elektronischen Steuerungseinheit (MK) anliegt.

**10.** Vorrichtung nach einem der Ansprüche 8 oder 9,

- wobei der Potentialpunkt der Verzerrsignal-Referenzpunkt (VRP) ist.

**11.** Vorrichtung nach einem der Ansprüche 8 bis 10,

- wobei zwischen dem Verzerrsignal-Ausgang (P3, D) und dem Potentialpunkt ein Widerstand (R1) geschaltet ist, und
- wobei der Potentialpunkt über einen Glättungskondensator (C1) mit einem Bezugspotential oder mit der Versorgungsspannung verbunden ist.

**12.** Vorrichtung nach einem der Ansprüche 8 bis 11,

- wobei an dem Verzerrsignal-Ausgang (P3, D) ein gepulstes Signal, insbesondere mit vorgebbarem Tastverhältnis, anliegt.

**13.** Vorrichtung nach einem der vorhergehenden Ansprüche,

- wobei der Kennwert eine Amplitude, eine Phase, ein Realteil und/oder ein Imaginärteil ist.

**Claims**

**1.** Apparatus for measuring a measured variable, having

- a first inductance (LP),
- at least one measurement inductance (LS1, LS2, LS3) that is designed to sense the measured variable and that is coupled to the first inductance (LP),
- a capacitance (CP) that is interconnected with the first inductance (LP) to form a parallel resonant circuit (P), and
- an electronic control unit (MK),
- wherein the electronic control unit (MK) is connected directly to the parallel resonant circuit (P) and is configured to excite the parallel resonant circuit (P) into oscillation at an excitation frequency that is derived from a clock of the electronic control unit (MK),
- wherein the electronic control unit (MK) has at least one analog-to-digital converter having a signal input (P4, P5, P6) connected directly to the at least one measurement inductance (LS1, LS2, LS3) for picking up a signal,
- wherein the electronic control unit (MK) has a distortion signal generator having a distortion signal output (P3, D), the distortion signal generator being designed to deliver a distortion signal at a distortion signal reference point (VRP),
- wherein the distortion signal output (D) is coupled to the analog-to-digital converter exclusively by means of passive components,
- wherein the electronic control unit (MK) is configured to measure the signal at intervals, a number of measured values being picked up within each interval, and
- wherein the electronic control unit (MK) is configured to perform a frequency analysis of the measured values of a respective interval and to determine at least one characteristic value, indicating the measured variable, of the signal at an evaluation frequency.

**2.** Apparatus according to Claim 1,

- wherein the measured values are spaced apart by respective time differences, these being consistent with an undersampling of the signal.

**3.** Apparatus according to either of the preceding claims,

- wherein the evaluation frequency is the excitation frequency.

**4.** Apparatus according to one of the preceding claims,

- wherein the evaluation frequency is an alias of the excitation frequency, in particular taking into consideration aliasing.

**5.** Apparatus according to one of the preceding claims,

    - wherein a respective measurement interval comprises an integer number of periods of the signal.

**6.** Apparatus according to one of the preceding claims,

    - wherein a respective measurement interval has an integer number of half-cycles of the distortion signal, preferably one or two half-cycles.

**7.** Apparatus according to one of the preceding claims,

    - wherein the distortion signal output (D) is coupled to the analog-to-digital converter without active components, in particular without operational amplifiers.

**8.** Apparatus according to one of the preceding claims,

    - wherein the measurement inductances (LS1, LS2, LS3) have a respective first pole connected to a respective signal input (P4, P5, P6) of the electronic control unit (MK), and have a respective second pole connected to a common potential point.

**9.** Apparatus according to Claim 8,

    - wherein at least approximately half the supply voltage of the electronic control unit (MK) is present at the potential point.

**10.** Apparatus according to either of Claims 8 and 9,

    - wherein the potential point is the distortion signal reference point (VRP).

**11.** Apparatus according to one of Claims 8 to 10,

    - wherein a resistor (R1) is connected between the distortion signal output (P3, D) and the potential point, and
    - wherein the potential point is connected to a reference-ground potential or to the supply voltage via a smoothing capacitor (C1).

**12.** Apparatus according to one of Claims 8 to 11,

    - wherein a pulsed signal, in particular having a pre-scribable duty ratio, is present at the distortion signal output (P3, D).

**13.** Apparatus according to one of the preceding claims,

    - wherein the characteristic value is an amplitude, a phase, a real part and/or an imaginary part.

**Revendications**

**1.** Dispositif permettant de mesurer une grandeur de mesure, présentant

    - une première inductance (LP),
    - au moins une inductance de mesure (LS1, LS2, LS3) qui est réalisée pour détecter la grandeur de mesure, et qui est couplée à la première inductance (LP),
    - une capacité (CP) qui est connectée avec la première inductance (LP) pour former un circuit oscillant parallèle (P), et
    - une unité de commande électronique (MK),
    - dans lequel l'unité de commande électronique (MK) est reliée directement au circuit oscillant parallèle (P), et est configurée pour faire osciller le circuit oscillant parallèle (P) à une fréquence d'excitation qui est dérivée d'une fréquence d'horloge de l'unité de commande électronique (MK),

- l'unité de commande électronique (MK) présentant au moins un convertisseur analogique/numérique doté d'une entrée de signal (P4, P5, P6) qui est reliée directement à ladite au moins une inductance de mesure (LS1, LS2, LS3) pour enregistrer un signal,
- l'unité de commande électronique (MK) présentant un générateur de signal de distorsion doté d'une sortie de signal de distorsion (P3, D), le générateur de signal de distorsion étant réalisé pour fournir un signal de distorsion au niveau d'un point de référence de signal de distorsion (VRP),
- la sortie de signal de distorsion (D) étant couplée au convertisseur analogique/numérique exclusivement au moyen de composants passifs,
- dans lequel l'unité de commande électronique (MK) est configurée pour mesurer le signal à intervalles, un nombre de valeurs mesurées étant enregistré à l'intérieur de chaque intervalle, et
- l'unité de commande électronique (MK) étant configurée pour effectuer une analyse de fréquence des valeurs mesurées d'un intervalle respectif, et pour déterminer au moins une valeur caractéristique indiquant la grandeur de mesure du signal à une fréquence d'évaluation.

2. Dispositif selon la revendication 1,

- dans lequel les valeurs mesurées sont espacées par des différences temporelles respectives, ces dernières correspondant à un sous-échantillonnage du signal.

3. Dispositif selon l'une quelconque des revendications précédentes,

- dans lequel la fréquence d'évaluation est la fréquence d'excitation.

4. Dispositif selon l'une quelconque des revendications précédentes,

- dans lequel la fréquence d'évaluation est un repliement de la fréquence d'excitation, en particulier en tenant compte d'un repliement de spectre.

5. Dispositif selon l'une quelconque des revendications précédentes,

- dans lequel un intervalle de mesure respectif comprend un nombre entier de périodes du signal.

6. Dispositif selon l'une quelconque des revendications précédentes,

- dans lequel un intervalle de mesure respectif présente un nombre entier de demi-périodes du signal de distorsion, de préférence une ou deux demi-périodes.

7. Dispositif selon l'une quelconque des revendications précédentes,

- dans lequel la sortie de signal de distorsion (D) est couplée sans composants actifs, en particulier sans amplificateur opérationnel, au convertisseur analogique/numérique.

8. Dispositif selon l'une quelconque des revendications précédentes,

- dans lequel les inductances de mesure (LS1, LS2, LS3) sont connectées par un premier pôle respectif à une entrée de signal (P4, P5, P6) respective de l'unité de commande électronique (MK), et sont reliées par un deuxième pôle respectif à un point de potentiel commun.

9. Dispositif selon la revendication 8,

- dans lequel au moins approximativement la moitié de la tension d'alimentation de l'unité de commande électronique (MK) est appliquée au point de potentiel.

10. Dispositif selon l'une quelconque des revendications 8 et 9,

- dans lequel le point de potentiel est le point de référence de signal de distorsion (VRP).

**11.** Dispositif selon l'une quelconque des revendications 8 à 10,

- dans lequel une résistance (R1) est connectée entre la sortie de signal de distorsion (P3, D) et le point de potentiel, et
- le point de potentiel étant relié par un condensateur de filtrage (C1) à un potentiel de référence ou à une tension d'alimentation.

**12.** Dispositif selon l'une quelconque des revendications 8 à 11,

- dans lequel un signal pulsé, en particulier ayant un rapport cyclique prédéfinissable, est appliqué à la sortie de signal de torsion (P3, D).

**13.** Dispositif selon l'une quelconque des revendications précédentes,

- dans lequel la valeur caractéristique est une amplitude, une phase ou une composante réelle et/ou une composante imaginaire.

Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2105713 A1
- EP 2765391 A2
- DE 69322762 T2
- WO 2017025354 A1